# EUROPEAN PATENT APPLICATION

(11) **EP 1 793 429 A1**
(43) Date of publication of application: **06.06.2007**
(21) Application number: 06024744.2
(22) Date of filing: 29.11.2006
(51) Int. Cl.: H01L 33/00, H01L 21/24

(54) **Semiconductor light emitting device having a reflection layer comprising silver**

(30) Priority: 01.12.2005 JP 2005348294
(71) Applicant: SONY CORPORATION, Tokyo (JP)
(72) Inventor: Watanabe, Yoshiaki, Shinagawa-ku, Tokyo (JP); Hino, Tomonori, Shinagawa-ku, Tokyo (JP); Kobayashi, Toshimasa, Shinagawa-ku, Tokyo (JP); Narui, Hironobu, Shinagawa-ku, Tokyo (JP)
(74) Representative: Müller - Hoffmann & Partner

(57) **Abstract**

A semiconductor light emitting device having high reflectivity and a high electrical contact property between a light reflection layer (30) and a semiconductor layer is provided. The semiconductor light emitting device is formed by laminating a semiconductor layer, a light reflection layer (30) and a protective layer (31) on a substrate in this order. The semiconductor layer is formed by laminating a buffer layer (21), a GaN layer (22), an n-type contact layer (23), an n-type cladding layer (24), an active layer (25), a p-type cladding layer (26) and a p-type contact layer (27) in this order. The light reflection layer (30) is formed by depositing an Ag alloy on a surface of the p-type contact layer (27) while heating the substrate at, for example, a temperature from 100°C to less than 400°C. After the semiconductor layer, the light reflection layer (30) and the protective layer (31) are formed, the semiconductor layer, the light reflection layer (30) and the protective layer (31) are heated in a predetermined time range at an ambient temperature within a higher temperature range than a temperature range at the time of heating the substrate.

## Description

### CROSS REFERENCES TO RELATED APPLICATIONS

The present invention contains subject matter related to Japanese Patent Application JP 2005-348294 filed in the Japanese Patent Office on December 1, 2005, the entire contents of which being incorporated herein by reference.

### BACKGROUND OF THE INVENTION

### 1. Field of the Invention

The present invention relates to a semiconductor light emitting device having a structure in which a light reflection layer reflects light emitted in a direction opposite to an emitting window toward the emitting window, and a method of manufacturing the semiconductor light emitting device.

### 2. Description of the Related Art

The external quantum efficiency of semiconductor light emitting devices such as light emitting diodes (LEDs) includes two factors, that is, internal quantum efficiency and light extraction efficiency, and a semiconductor light emitting device with a long life, low power consumption and high power can be achieved by improving these efficiencies. The former efficiency, that is, internal quantum efficiency is improved, for example, by controlling growth conditions correctly so as to obtain a good crystal with less crystal defects or less dislocation, or by having a layer structure capable of preventing the occurrence of a carrier overflow. On the other hand, the latter efficiency, that is, the light extraction efficiency is improved, for example, by having a geometric shape or a layer structure increasing the rate at which light emitted from an active layer enters an emitting window at angles inside an escape cone before the light is absorbed by a substrate or the active layer. Moreover, the light extraction efficiency can be improved by arranging a light reflection layer made of a material with high reflectivity so as to reflect light emitted in a direction opposite to the emitting window toward the emitting window.

In semiconductor light emitting devices such as light emitting diodes, the above-described light reflection layer typically has a role as an electrode injecting a current into a semiconductor layer; therefore, it is necessary for the light reflection layer to have a high electrical contact property with various semiconductor layers. Typically, as a material with a high electrical contact property with various semiconductor layers and high versatility, Al (aluminum), Au (gold), Pt (platinum), Ni (nickel), Pd (palladium) or the like is used. However, even if they are used for the light reflection layer, the reflectivity is not much increased, so in many cases, they are not suitable for applications which need high reflectivity.

It can be considered that Ag (silver) which has extremely high reflectivity is applied to the light reflection layer in such applications. Ag has a high electrical contact property with a long-wavelength range semiconductor layer such as an AlGaAs-based semiconductor or an AlGaInP-based semiconductor, so an ohmic contact is easily formed. However, Ag has a low electrical contact property with a short-wavelength range semiconductor layer such as a GaN-based semiconductor, so an ohmic contact close to a schottky contact is easily formed, compared to any other materials, so linearity declines. Thus, Ag has a low electrical contact property with a short-wavelength range semiconductor layer such as a GaN-based semiconductor. Therefore, in Japanese Unexamined Patent Application Publication No. 2004-260178, there have been proposed a technique of arranging an extremely thin layer of 0.1 nm to 0.5 nm thick including Pt, Pd or Ni between a light reflection layer made of Ag and a semiconductor layer, and a technique of heating a light reflection layer made of Ag at a low temperature (300°C) in consideration of the heat resistance of Ag.

### SUMMARY OF THE INVENTION

In the former technique of Japanese Unexamined Patent Application Publication No. 2004-260178, the electrical contact property can be improved. However, as a layer made of a material with low reflectivity is arranged between a light reflection layer and a semiconductor layer, the reflectivity declines inevitably, thereby high reflectivity is not expected. In the latter technique, as a light reflection layer made of Ag makes direct contact with a semiconductor layer, the reflectivity is high. However, even if the light reflection layer is simply heated at a low temperature, a schottky contact is hardly changed into an ohmic contact, so the electrical contact property is still low. As described above, in Japanese Unexamined Patent Application Publication No. 2004-260178, only either the reflectivity or the electrical contact property can be improved.

In view of the foregoing, it is desirable to provide a semiconductor light emitting device having high reflectivity and a high electrical contact property between a light reflection layer and a semiconductor layer, and a method of manufacturing the semiconductor light emitting device.

According to an embodiment of the invention, there is provided a method of manufacturing a semiconductor light emitting device including the steps of: laminating a first conductive layer, an active layer and a second conductive layer on a transparent substrate in this order; forming a light reflection layer by depositing Ag and a predetermined material on a surface of the second conductive layer while heating the transparent substrate at a first temperature range; and after forming the light reflection layer, heating the first conductive layer, the active layer, the second conductive layer and the light reflection layer in a predetermined time range at a second temperature range, the second temperature range being higher than the first temperature range.

According to an embodiment of the invention, there is provided a semiconductor light emitting device including: a semiconductor layer formed by laminating a first conductive layer, an active layer and a second conductive layer on a transparent substrate in this order; and a light reflection layer formed by depositing Ag and a predetermined material on a surface of the second conductive layer while heating the transparent substrate at a first temperature range, wherein after the semiconductor layer and the light reflection layer are formed, the semiconductor layer and the light reflection layer are heated in a predetermined time range at an ambient temperature within a second temperature range, the second temperature range being higher than the first temperature range.

In the semiconductor light emitting device and the method of manufacturing a semiconductor light emitting device according to the embodiment of the invention, when the light reflection layer is deposited on the surface of the second conductive layer, the transparent substrate, and by extension to the semiconductor layer is heated at the first temperature range. Thereby, the disturbance of the crystal regularity in an interface with the light reflection layer in the second conductive layer is prevented, and in a state where moisture and an organic component is prevented from being deposited on the interface, the light reflection layer can be deposited on the surface of the second conductive layer. After that, the semiconductor layer and the light reflection layer are heated in a predetermined time range at an ambient temperature within the second temperature range higher than the first temperature range. Thereby, Ag included in the light reflection layer is dispersed into the second conductive layer to form a compound. As a result, the light reflection layer makes ohmic contact with the semiconductor layer, so the linearity of the light reflection layer and the semiconductor layer is increased. In addition, the light reflection layer includes Ag with extremely high reflectivity.

In the semiconductor light emitting device and the method of manufacturing a semiconductor light emitting device according to the embodiment of the invention, after the light reflection layer including Ag and the predetermined material is deposited on the surface of the second conductive layer while heating the transparent substrate at the first temperature range, the semiconductor layer and the light reflection layer are heated in a predetermined time range at an ambient temperature within the second temperature range higher than the first temperature range, so the light reflection layer makes ohmic contact with the semiconductor layer, and the light reflection layer can reflect light emitted from the semiconductor layer with high reflectivity. Thereby, a semiconductor light emitting device having high reflectivity and a high electrical contact property between the light reflection layer and the semiconductor layer can be achieved.

Other and further objects, features and advantages of the invention will appear more fully from the following description.

### BRIEF DESCRIPTION OF THE DRAWINGS

FIG. 1 is a sectional view of a light emitting diode according to an embodiment of the invention;
FIGs. 2A and 2B are sectional views of a light reflection layer in FIG. 1 formed by sputtering;
FIGs. 3A and 3B are sectional views of a light reflection layer in FIG. 1 formed by evaporation;
FIG. 4 is a simplified flowchart showing steps of manufacturing the light emitting diode;
FIGs. 5A and 5B are sectional views for describing steps of manufacturing the light emitting diode;
FIG. 6 is a relationship diagram for describing the reflectivity of the light emitting diode; and
FIG. 7 is a relationship diagram for describing current-voltage characteristics.

### DETAILED DESCRIPTION OF THE PREFERRED EMBODIMENTS

A preferred embodiment will be described in detail below referring to the accompanying drawings.

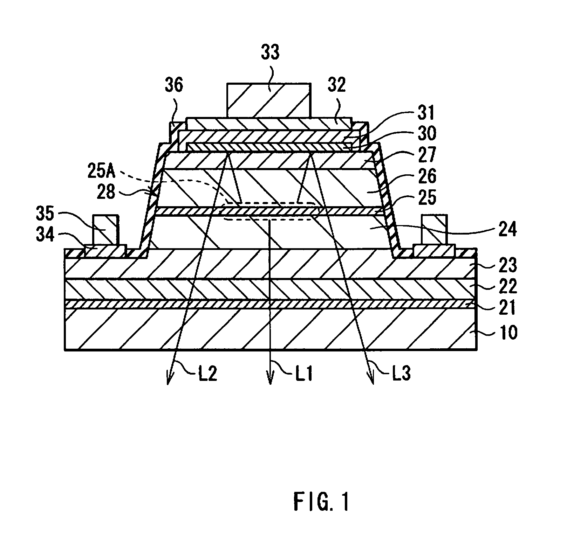

FIG. 1 shows a sectional view of a light emitting diode (LED) according to an embodiment of the invention. FIG. 1 is a schematic view, so dimensions and shapes in FIG. 1 are different from actual dimensions and shapes.

The light emitting diode is formed by growing a semiconductor layer 20 made of a nitride Group III-V compound semiconductor on a substrate 10. The semiconductor layer 20 is formed by laminating a buffer layer 21, a GaN layer 22, an n-type contact layer 23, an n-type cladding layer 24, an active layer 25, a p-type cladding layer 26 (a first p-type semiconductor layer) and a p-type contact layer 27 (a second p-type semiconductor layer) in this order.

The nitride Group III-V compound semiconductor here is a gallium nitride-based compound including gallium (Ga) and nitrogen (N), and examples of the gallium nitride-based compound include GaN, AlGaN (aluminum gallium nitride), AlGaInN (aluminum gallium indium nitride) and the like. They may include n-type impurities of Group IV and VI elements such as Si (silicon), Ge (germanium), O (oxygen) and Se (selenium) or p-type impurities of Group II and IV elements such as Mg (magnesium), Zn (zinc) and C (carbon), if necessary.

The substrate 10 is made of a transparent substrate, for example, c-plane sapphire. The buffer layer 21 is made of, for example, undoped GaN with a thickness of 30 nm, and is formed on the c-plane sapphire by low-temperature growth. The GaN layer 22 is made of, for example, undoped GaN with a thickness of 0.5 µm, and is formed on the c-plane sapphire with the buffer layer 21 in between through the use of a lateral direction crystal growth technique such as ELO (Epitaxial Lateral Overgrowth). The n-type contact layer 23 is made of, for example, n-type GaN with a thickness of 4.0 µm, and the n-type cladding layer 24 is made of, for example, n-type AlGaN with a thickness of 1.0 µm.

The active layer 25 has, for example, a multiquantum well structure in which three pairs of an undoped InₓGa₁₋ₓN well layer (0<x<1) with a thickness of 3.5 nm and an undoped In_{y}Ga_{1-y}N barrier layer (0<y<1) with a thickness of 7.0 nm are laminated. The active layer 25 has a light emitting region 25A where the recombination of electrons and holes produces photons in a central region of the active layer 25. The p-type cladding layer 26 is made of, for example, p-type AlGaN with a thickness of 0.5 µm.

The p-type contact layer 27 is made of, for example, p-type GaN with a thickness of 0.1 µ m, and has a higher concentration of p-type impurities than the p-type cladding layer 26. An interface with a light reflection layer 30 which will be described later in the p-type contact layer 27 has extremely good crystal regularity as a result of substrate heating which will be described later, and impurities such as moisture or an organic component are hardly deposited on the interface. Moreover, the p-type contact layer 27 includes a compound formed by reacting with Ag dispersed from the light reflection layer 30 by a heat treatment (sintering) which will be described later in an interface with the light reflection layer 30 and its surroundings.

As will be described later, a portion from the p-type contact layer 27 to the top portion of the n-type contact layer 23 is selectively etched to form a convex mesa 28 in a top portion of the n-type contact layer 23, the n-type cladding layer 24, the active layer 25, the p-type cladding layer 26 and the p-type contact layer 27.

The light reflection layer 30 and a protective layer 31 are laminated in this order on a part of a top surface of the mesa 28, that is, a top surface of the p-type contact layer 27.

The light reflection layer 30 is made of a material having metallic properties, for example, an Ag alloy with a thickness from 70 nm to 200 nm. The Ag alloy is formed by adding at least one selected from the group consisting of Pt (platinum), Pd (palladium), Au (gold), Cu (copper), In (indium) and Ga (gallium) to Ag, and the light reflection layer 30 may be made of so-called APC including, for example, 98% of Ag, 1% of Pd and 1% of Cu. Depending on the composition of the Ag alloy, in the case where the Ag alloy includes, for example, Pd, Cu, In and the like, even if the Ag alloy is heated at a high temperature exceeding 200°C, there is little possibility of a decline in optical characteristics (reflectivity) due to migration, aggregation or the like. Therefore, compared to pure Ag causing the above-described phenomenon at approximately 200°C, the Ag alloy has extremely large heat resistance.

While the Ag alloy overcomes the above-described disadvantages of pure Ag, the Ag alloy has extremely large reflectivity like pure Ag. Thereby, the light reflection layer 30 has a function of reflecting light traveling in a direction opposite to the substrate 10 as an emitting window of light emitted from the light emitting region 25A of the active layer 25 toward the substrate 10. Moreover, the light reflection layer 30 is electrically connected to a p-side bump 33 which will be described later, so the light reflection layer 30 also has a function as a p-side electrode. Therefore, it is necessary for the light reflection layer 30 to have a high electrical contact property with the p-type contact layer 27. The light reflection layer 30 makes ohmic contact with the p-type contact layer 27, so the light reflection layer 30 has a high electrical contact property.

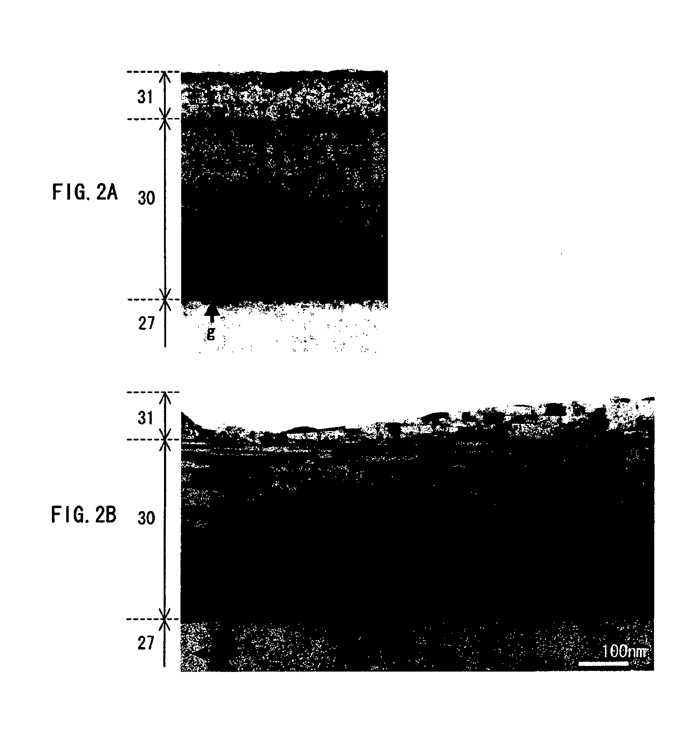

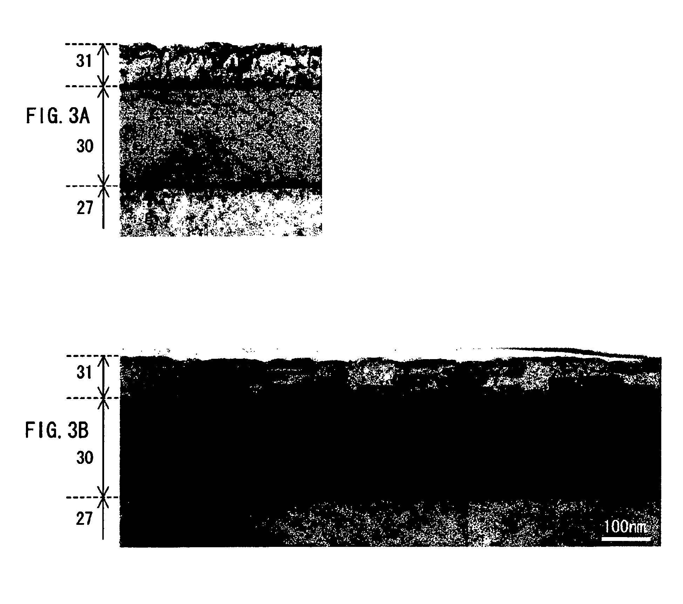

Now, structural differences caused by different methods of laminating an Ag alloy will be described below. FIGs. 2A and 2B show an example of a sectional structure of the light reflection layer 30 formed by sputtering, and FIGs. 3A and 3B show an example of a sectional structure of the light reflection layer 30 formed by evaporation. FIGs. 2A and 3A are sectional views taken along a direction parallel to a laminating direction by a TEM (Transmission Electron Microscope), and FIGs. 2B and 3B are sectional views taken along a direction perpendicular to the laminating direction by the TEM.

It is obvious that in the light reflection layer 30 formed by sputtering, patterns (grains) formed at a grain boundary is extremely fine, and they are laminated in layers. On the other hand, in the light reflection layer 30 formed by evaporation, grains are extremely large, and the light reflection layer 30 does not have a laminating pattern observed in the light reflection layer 30 formed by sputtering. Therefore, it is found out that when the light reflection layer 30 is formed by sputtering, the grains of the light reflection layer 30 can become very fine as shown in FIGs. 2A and 2B. Thus, when the grains are very fine, reactivity to oxidation or sulfurization can be lowered, so the light reflection layer 30 is less subject to an influence from external environment. Moreover, adhesion can be extremely large, thereby peeling of the light reflection layer 30 can be prevented. Accordingly, the light reflection layer 30 is formed more preferably by sputtering than by evaporation.

The protective layer 31 is made of a material capable of protecting the light reflection layer 30 from high temperatures by the heat treatment (sintering) which will be described later, for example, at least one selected from the group consisting of Ni (nickel), Ti (titanium) and Pt, and the protective layer 31 has, for example, a thickness of 100 nm. Compared to the case where the protective layer 31 is not arranged, the upper limit of the temperature for the heat treatment, that is, the temperature at which the light reflection layer 30 is rapidly degraded can be increased. Thereby, even if the temperature for the heat treatment is increased to shorten a processing time, the protective layer 31 can minimize the degradation in the light reflection layer 30.

A p-side pad portion 32 is formed on a part of the top surface of a protective layer 31, and the p-side bump 33 is formed on a part of the top surface of the p-side pad portion 32. The p-side pad portion 32 has, for example, a structure in which Ti of 50 nm thick, Ni of 100 nm thick and Au of 300 nm thick are laminated in this order. The p-side bump 33 is made of, for example, Au of 5000 nm thick.

An n-side electrode 34 is formed on a part along the outer edge of the mesa 28 in the surface of the n-type contact layer 23, and an n-side bump 35 is formed on a part of the top surface of the n-side electrode 34. The n-side electrode 34 has, for example, a structure in which Ti of 50 nm thick, Ni of 100 nm thick and Au of 300 nm thick are laminated in this order. The n-side bump 35 is made of, for example, Au of 5000 nm thick. An insulating layer 37 is formed on the side surfaces of the mesa 28 and the protective layer 31 and an exposed portion of the n-type contact layer 23. The insulating layer 37 is made of, for example, SiN of 300 nm thick.

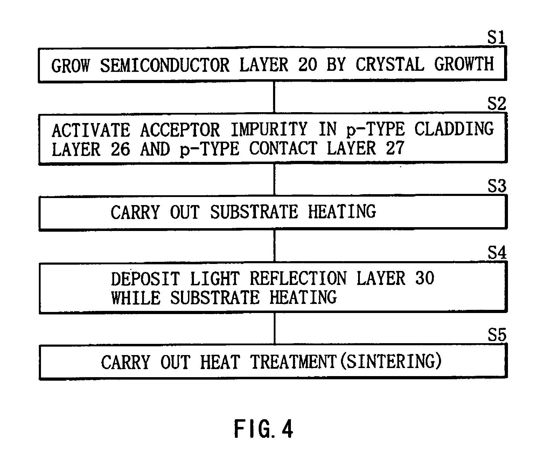

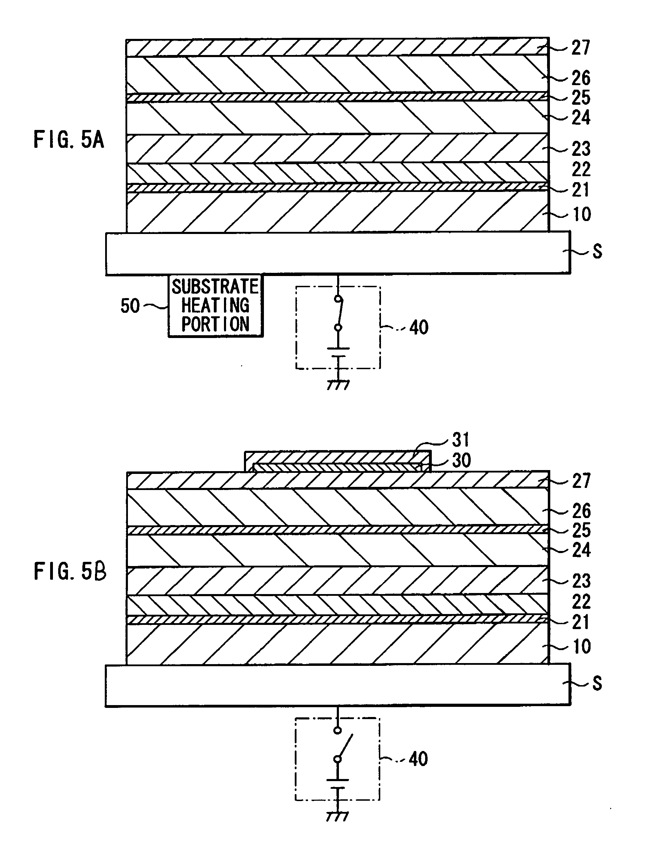

Next, an example of a method of manufacturing a light emitting diode with such a structure will be described in detail referring to FIGs. 4, 5A and 5B. FIG. 4 shows a simplified flowchart of steps of manufacturing the light emitting diode, and FIGs. 5A and 5B show sectional structures of the light emitting diode in manufacturing steps.

To manufacture the light emitting diode, the semiconductor layer 20 made of a nitride Group III-V compound semiconductor is formed on the substrate 10 made of c-plane sapphire by, for example, MOCVD (Metal Organic Chemical Vapor Deposition). At this time, as the material of the GaN-based compound semiconductor, for example, trimethyl aluminum (TMA), trimethyl gallium (TMG), trimethyl indium (TMIn), or ammonia (NH₃) is used, and as the material of a donor impurity, for example, silane (SiH₄) is used, and as the material of an acceptor impurity, for example, bis(methylcyclopentadienyl)magnesium ((CH₃C₅H₄)₂Mg) or bis(cyclopentadienyl)magnesium ((C₅H₅)₂Mg) is used.

At first, the surface of the substrate is cleaned by, for example, thermal cleaning. Next, the buffer layer 21A is grown on the cleaned substrate 10 by, for example, MOCVD at, for example, approximately 500°C, and then the GaN layer 22 is grown by, for example, a lateral direction crystal growth technique such as ELO at, for example, a growth temperature of 1000°C.

Next, the n-type contact layer 23, the n-type cladding layer 24, the active layer 25, the p-type cladding layer 26 and the p-type contact layer 27 are grown in order on the GaN layer 22 by, for example, MOCVD. In this case, the growth temperatures of the n-type contact layer 23, the n-type cladding layer 24, the p-type cladding layer 26 and the p-type contact layer 27 all of which do not include In are, for example, approximately 1000°C, and the growth temperature of the active layer 25 including In is, for example, 700°C to 800°C. After the semiconductor layer 20 is grown in such a manner by crystal growth (step S1), a heat treatment is carried out at, for example, 600°C to 700°C for several tens of minutes to activate the acceptor impurity in the p-type cladding layer 26 and the p-type contact layer 27 (step S2).

Next, a resist pattern (not shown) with a predetermined shape corresponding to the shape of the mesa 28 is formed on the p-type contact layer 27, and etching is carried out through the use of the resist pattern as a mask until reaching the n-type contact layer 23 by, for example, RIE (Reactive Ion Etching) using a chlorine-based gas to form the mesa 28.

Then, as shown in FIG. 5A, after the substrate 10 on which the semiconductor layer 20 is formed is placed on a base S electrically connected to a substrate bias portion 40, the substrate 10 is heated via the base S at, for example, a temperature ranging from 100°C to less than 400°C (a first temperature range) for example, through the use of a substrate heating portion 50 (step S3). In the embodiment, driving the substrate bias portion 40 and the substrate heating portion 50 as described above is called substrate heating.

After that, the heat of the substrate 10 propagates to the semiconductor layer 20 to increase the temperature of the semiconductor layer 20, so in a region where the crystal regularity is disturbed in an interface where the light reflection layer 30 is formed of the p-type contact layer 27, the disturbance of the crystal regularity is reduced, and most of impurities such as moisture or an organic component deposited on the interface are removed. Thus, after the interface is brought close to a clean and ideal crystal state, while substrate heating is continued, the light reflection layer 30 and the protective layer 31 are deposited on the p-type contact layer 27 (step S4).

In the case where, for example, sputtering is used to deposit the light reflection layer 30, plasma power for sputtering a target is preferably minimized, and more specifically, the minimum power capable of stably maintaining a plasma discharge (depending on the structure of a plasma device, for example, 1 W/cm² or less at a pressure of 10 Pa) is preferable, because damages can be minimized by sputtering. In the case where sputtering is used, a potential difference between the target and the substrate 10 (in the above conditions, for example, approximately 100 V to 300 V) is generated, and the substrate 10 is biased, so the substrate 10 can be biased without the substrate bias portion 40.

Thus, when substrate heating is carried out during sputtering, the light reflection layer 30 can be deposited while recovering the crystallinity in the interface damaged by sputtering. Thereby, a decline in a contact property between the light reflection layer 30 and the p-type contact layer 27 can be prevented, and in a subsequent heat treatment (sintering), the light reflection layer 30 can easily make ohmic contact with the p-type contact layer 27.

Next, after stopping substrate heating, as shown in FIG. 5B, the semiconductor layer 20, the light reflection layer 30 and the protective layer 31 are subjected to a heat treatment (sintering) at an ambient temperature within a higher temperature range (a second temperature range) than a temperature range at the time of substrate heating in a predetermined time range (step S5).

The ambient temperature range is preferably a temperature or higher at which Ag included in the light reflection layer 30 can be dispersed into the p-type contact layer 27, and a temperature lower than a temperature at which the light reflection layer 30 is rapidly degraded. The temperature range has time dependence, that is, the shorter the heat treatment time is, the higher the temperature range is shifted, and the longer the heat treatment time is, the lower the temperature range is shifted. On the other hand, the time range in the heat treatment is preferably a time or longer in which Ag included in the light reflection layer 30 can be dispersed into the p-type contact layer 27 on the basis of the set temperature and the thickness and thermal conductivity of the light reflection layer 30. In this case, in the case where the set temperature is high, the heat treatment time is shortened so that Ag can be dispersed into the p-type contact layer 27 without degrading the light reflection layer 30, and in the case where the set temperature is low, the heat treatment time is extended so that Ag can be dispersed into the p-type contact layer 27.

When the above-described sintering is carried out, Ag is dispersed from the light reflection layer 30 to the p-type contact layer 27 to react with a predetermined component in the p-type contact layer 27, thereby a compound is formed in an interface with the light reflection layer 30 in the p-type contact layer 27 and its surroundings. At this time, a component in the p-type contact layer 27 is dispersed from the p-type contact layer 27 to the light reflection layer 30 to react with a predetermined component in the light reflection layer 30, thereby a compound may be formed in an interface with the p-type contact layer 27 in the light reflection layer 30 and its surroundings.

Thus, when a compound is formed in either or both of the interfaces of the light reflection layer 30 and the p-type contact layer 27 and their surroundings, the cohesion of each of the interfaces of the light reflection layer 30 and the p-type contact layer 27 is increased, and adhesion is increased. Moreover, the light reflection layer 30 makes ohmic contact with the p-type contact layer 27, so an electrical contact property becomes extremely high. Thereby, when sintering is carried out in addition to substrate heating, the electrical contact property between the light reflection layer 30 and the p-type contact layer 27 can be improved.

Finally, the p-side pad portion 32, the p-side bump 33, the n-side electrode 34 and the n-side bump 35 are formed in order. Thus, the light emitting diode according to the embodiment is manufactured.

In the light emitting diode manufactured in such a manner, when a current is supplied to the p-side bump 33 and the n-side bump 35, the current is injected into the light emitting region 25A of the active layer 25, thereby light is emitted by the recombination of electrons and holes. Light L1 directly toward the substrate 10 as an emitting window in the light emitted from the light emitting region 25A passes through the substrate 10 to be emitted to outside, and lights L2 and L3 in a direction opposite to the substrate 10 as the emitting window are reflected to the substrate 10 by the light reflection layer 30, and then pass through the substrate 10 to be emitted to outside.

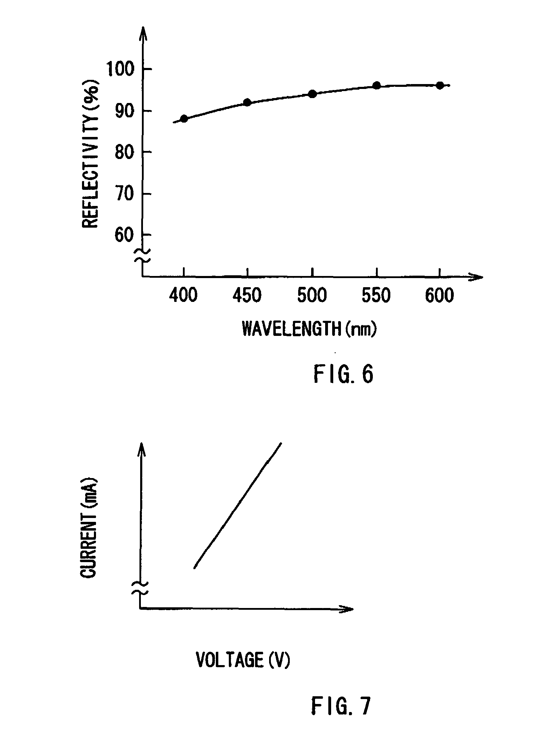

At this time, the lights L2 and L3 are reflected by the light reflection layer 30 including Ag with extremely large reflectivity, so compared to the case where the lights L2 and L3 are reflected by a reflection layer not including Ag, the reflectivity and the light extraction efficiency are extremely large. For example, the reflectivity can be approximately 95% throughout a wide wavelength range as shown in FIG. 6.

Moreover, as shown in FIG. 7, the current-voltage characteristics of the light emitting diode are substantially linear, so it is obvious that the light reflection layer 30 electrically connected to the p-side bump 33 makes ohmic contact with the p-type contact layer 27. Thereby, when the p-side bump 33 and the n-side bump 35 are driven, the contact resistance between the light reflection layer 30 and the p-type contact layer 27 can be reduced, thereby as a result, a drive voltage can be reduced.

Thus, in the embodiment, after the light reflection layer 30 is formed while carrying out substrate heating, the light reflection layer 30 is heated (sintered), so in spite of the fact that the light reflection layer 30 makes direct contact with the p-type contact layer 27, the light reflection layer 30 can make ohmic contact with the p-type contact layer 27. Moreover, the light reflection layer 30 makes direct contact with the p-type contact layer 27, so light emitted from the semiconductor layer 20 can be reflected with high reflectivity. Thereby, a light emitting diode having high reflectivity of the light reflection layer 30 and a high electric contact property between the light reflection layer 30 and the p-type contact layer 27 can be achieved.

Moreover, for example, as a result of an experiment that the light emitting diode emits light for 300 hours in the atmosphere of high temperature and high humidity (70°C, 90%), the light reflection layer 30 are not degraded or peeled. Therefore, it is obvious that the adhesion of the light reflection layer 30 and the p-type contact layer 27 is extremely high. At this time, the variability rate of the reflectivity is approximately 0.5% which is within a measurement error tolerance range, so it is obvious that the variation of the reflectivity is extremely small.

Although the invention is described referring to the embodiment and the modification, the invention is not limited to the embodiment and the modification, and can be variously modified.

For example, in the above embodiment, after the light reflection layer 30 is covered with the protective layer 31, the heat treatment (sintering) is carried out. However, the heat treatment (sintering) may be carried out in a state where the light reflection layer 30 is exposed in a nitrogen atmosphere.

Moreover, in the above embodiment, the light emitting diode including a nitride Group III-V compound semiconductor is described; however, the invention is not limited to this, and the invention is applicable to a long-wavelength range light emitting diode including any other semiconductor material, for example, an AlGaAs-based or AlGaInP-based semiconductor.

It should be understood by those skilled in the art that various modifications, combinations, sub-combinations and alterations may occur depending on design requirements and other factors insofar as they are within the scope of the appended claims or the equivalents thereof.

## Claims

1. A method of manufacturing a semiconductor light emitting device comprising the steps of:
laminating a first conductive layer (24), an active layer (25) and a second conductive layer (26) on a transparent substrate (10) in this order;
forming a light reflection layer (30) by depositing Ag (silver) and a predetermined material on a surface of the second conductive layer (26) while heating the transparent substrate (10) at a first temperature range; and
after forming the light reflection layer (30), heating the first conductive layer (24), the active layer (25), the second conductive layer (26) and the light reflection layer (30) in a predetermined time range at a second temperature range, the second temperature range being higher than the first temperature range.

2. The method of manufacturing a semiconductor light emitting device according to claim 1, wherein
the first temperature range is from 100°C to less than 400°C.

3. The method of manufacturing a semiconductor light emitting device according to claim 1, wherein
the predetermined material includes at least one selected from the group consisting of Pt (platinum), Pd (palladium), Au (gold), Cu (copper), In (indium) and Ga (gallium).

4. The method of manufacturing a semiconductor light emitting device according to claim 1, wherein
the light reflection layer (30) is formed by sputtering.

5. The method of manufacturing a semiconductor light emitting device according to claim 1, wherein
the second conductive layer (26) is formed by laminating a first p-type semiconductor layer and a second p-type semiconductor layer in this order, the first p-type semiconductor layer and the second p-type semiconductor layer made of a Group III-V nitride semiconductor, and
the second p-type semiconductor layer has a higher p-type impurity concentration than the first p-type semiconductor layer.

6. A semiconductor light emitting device comprising:
a semiconductor layer formed by laminating a first conductive layer (24), an active layer (25) and a second conductive layer (26) on a transparent substrate (10) in this order; and
a light reflection layer (30) formed by depositing Ag and a predetermined material on a surface of the second conductive layer (26) while heating the transparent substrate (10) at a first temperature range,
wherein after the semiconductor layer and the light reflection layer (30) are formed, the semiconductor layer and the light reflection layer (30) are heated in a predetermined time range at an ambient temperature within a second temperature range, the second temperature range being higher than the first temperature range.

7. The semiconductor light emitting device according to claim 6,
wherein
the predetermined material includes at least one selected from the group consisting of Pt (platinum), Pd (palladium), Au (gold), Cu (copper), In (indium) and Ga (gallium).
